(19) Europäisches Patentamt

European Patent Office

Office européen des brevets

(11) **EP 0 555 748 B1**

(12) **EUROPÄISCHE PATENTSCHRIFT**

(45) Veröffentlichungstag und Bekanntmachung des Hinweises auf die Patenterteilung:
**13.05.1998 Patentblatt 1998/20**

(51) Int Cl.⁶: **H03G 5/12**, H03F 3/08

(21) Anmeldenummer: **93101630.7**

(22) Anmeldetag: **03.02.1993**

(54) **Gegengekoppelte Verstärkerstufe**

Amplifier stage with negative feedback

Etage amplificateur à contre-réaction

(84) Benannte Vertragsstaaten:
**AT CH DE FR GB LI NL**

(30) Priorität: **14.02.1992 DE 4204324**

(43) Veröffentlichungstag der Anmeldung:
**18.08.1993 Patentblatt 1993/33**

(73) Patentinhaber: **ROBERT BOSCH GMBH**
**70442 Stuttgart (DE)**

(72) Erfinder:
- **Flassnöcker, Volkhard, Dipl.-Ing.**
**W-7100 Heilbronn (DE)**
- **Rein, Hans-Martin, Prof. Dr. Ing.**
**W-5810 Witten 3 (DE)**

(56) Entgegenhaltungen:
**EP-A- 0 242 439**        **BE-A- 649 319**

- **NACHRICHTEN TECHNIK ELEKTRONIK Bd. 35, Nr. 11, 1985, BERLIN DD Seiten 429 - 431; W. BAIER ET AL 'GEGENGEKOPPELTE DOPPELSTUFE IN OPTISCHEN EMPFAENGERN'**
- **RADIO FERNSEHEN ELEKTRONIK Bd. 26, Nr. 9, 1977, BERLIN DD Seite 316 'FELDSTAERKEABHAENGIGE BANDBREITEN-REGELUNG IN AM-RUNDFUNKEMPFAENGERN'**

**Beschreibung**

Die Erfindung geht aus von einer Verstärkerstufe, insbesondere für Empfangseinrichtungen optischer Übertragungssysteme mit einem Kondensator im Gegenkopplungszweig.

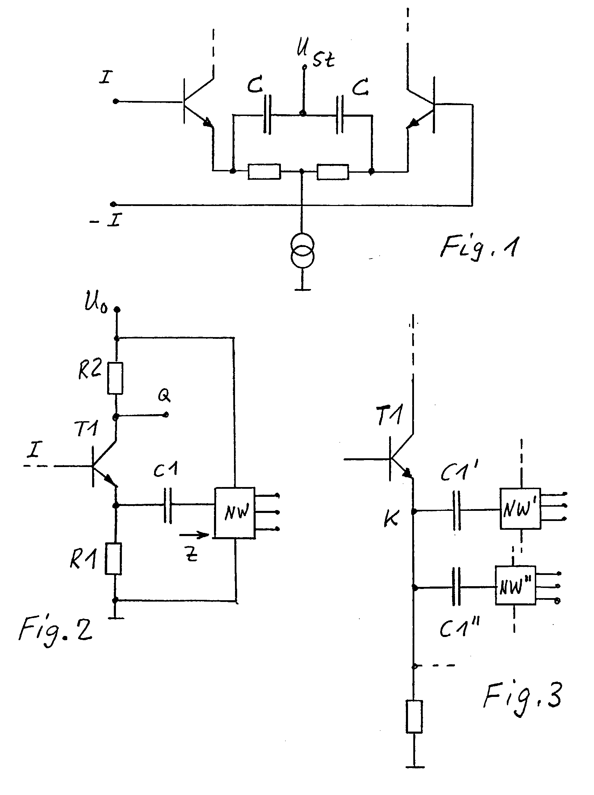

Verstärkerstufen, zum Beispiel Emitterfolger, werden gleichstrommäßig über einen Emitterwiderstand gegengekoppelt. Hochfrequenzmäßig ist dieser Emitterwiderstand meist mit einem Kondensator überbrückt. Eine optimale Anpassung einer solchen Verstärkerstufe an nachfolgende Schaltungen bezüglich des Frequenzganges ist oft nicht erreichbar. Im Eintaktbetrieb ist der Wert des Kondensators nicht einstellbar. Bei Differenzverstärkerstufen (Figur 1) ist der Wert des Gegenkopplungskondensators C über die Steuerspannung $U_{St}$ zwar einstellbar, jedoch nur in einem eng begrenzten Bereich. Dies setzt außerdem voraus, daß der Kondensator C als pn-Übergang (Kapazitätsdiode) realisiert ist, zum Beispiel [1] bis [3].

Aus der BE-A 649319 ist ein zweistufiger Breitbandverstärker bekannt, in dessen Gegenkopplungszweigen zu einem Kondensator ein weiterer einstellbarer Kondensator in Serie geschaltet ist. Durch zwei unterschiedliche Signalpfade läßt sich die Verstärkung ohne Beeinflussung der Phase einstellen. Aus Nachrichtentechnik Elektronik, Band 35 (1985), Seiten 429 bis 431, ist es bekannt, für Empfangseinrichtungen optischer Übertragungssysteme gegengekoppelte Verstärkerstufen zu verwenden, bei denen durch Regelung der Gegenkopplungswiderstände die Verstärkung variiert werden kann. Es werden dort lediglich einstellbare Wirkwiderstände zu den Gegenkopplungskondensatoren in Serie geschaltet. Die EP-0242439 A2 offenbart einen Breitband-Differenzverstärker mit aktiven RC-Gliedern in den Gegenkopplungszweigen.

Aufgabe der Erfindung ist es, eine gegengekoppelte Verstärkerstufe so auszubilden, daß der Frequenz- und Phasengang eines Verstärkers ohne wesentliche Änderung der Wechselsignalverstärkung individuell einstellbar ist. Diese Aufgabe wird durch die Merkmale des Anspruchs 1 gelöst. Die weiteren Ansprüche zeigen Weiterbildungen hierzu auf bzw. eine vorteilhafte Verwendung. Die Maßnahmen der Erfindung gestatten eine optimale Anpassung des Frequenz- und Phasengangs eines Verstärkers in einem gegebenen Übertragungssystem, dessen Systemdaten variieren können. Sie ermöglichen ferner, Unsicherheiten beim Entwurf und Schwankungen bei der Fertigung des Verstärkers nachträglich auszugleichen, was bei monolithisch integrierten Schaltungen besonders wichtig ist. Die Erfindung eignet sich z.B. für die Ausgangsstufe in einem Vorverstärker für optische Empfangssysteme mit Bitraten im Gbit/s Bereich.

Anhand der weiteren Zeichnungen werden Ausführungsbeispiele der Erfindung nun näher erläutert. Es zeigen

Fig. 2 ein Prinzipschaltbild einer Verstärkerstufe nach der Erfindung,
Fig. 3 ein Prinzipschaltbild mit mehreren Gegenkopplungsschleifen,
Fig. 4 ein Beispiel für ein einstellbares Netzwerk,
Fig. 5 eine Stromspiegelschaltung für die Einstellung des Netzwerkes,
Fig. 6 eine Schaltung zur Einstellung der am Kondensator des Netzwerks anliegenden Vorspannung,
Fig. 7 ein mögliches Ersatzschaltbild für das Netzwerk bei Resonanzüberhöhung,
Fig. 8 die Anhebung der Verstärkung in der Umgebung der Resonanzfrequenz,
Fig. 9 das Schaltbild eines Transimpedanzverstärkers und
Fig. 10 die Verstärkung des Transimpedanzverstärkers in Abhängigkeit der Frequenz.

Fig. 2 zeigt als Ausführungsbeispiel der Erfindung eine gegengekoppelte Verstärkerstufe (Transadmittanz-Stufe) mit dem Transistor T1. Der Eingang der Stufe ist mit I und der Ausgang mit Q bezeichnet. Zwischen der Versorgungsspannung $U_O$ und dem Kollektor liegt der Widerstand R2 und zwischen Emitter und Masse der Gegenkopplungswiderstand R1. An den Emitter ist ein Kondensator C1 angebunden, zu dem ein einstellbares Netzwerk NW in Serie geschaltet ist. Dieses Netzwerk NW weist eine einstellbare komplexe Ausgangsimpedanz Z auf, so daß parallel zum Widerstand R1 eine Serienschaltung aus Kondensator C1 und Ausgangsimpedanz Z liegt. Das Netzwerk NW erlaubt die individuelle Einstellung von Betrag und Phase des Frequenzganges der Verstärkerstufe in einem weiten Bereich ohne Änderung der NF-Verstärkung. In einer Weiterbildung der Erfindung ist das Netzwerk NW derart ausgestaltet, daß auch seine Ausgangsgleichspannung variiert werden kann. Am Ausgang liegt sowohl ein Gleichspannungsanteil UA als auch der für den Frequenzgang wichtige Wechselspannungsanteil. Einzelheiten über den Aufbau des Netzwerkes NW werden anschließend beschrieben. Ist der Kondensator als pn-Übergang ausgebildet, kann über die Variation der Ausgangsspannung die Kapazität des Kondensators C1 eingestellt werden, was zu einer höheren Flexibilität führt. Letztere Ausgestaltung erlaubt im Gegensatz zu den bekannten Lösungen auch die Einstellbarkeit im Eintaktbetrieb.

Eine weitere Erhöhung der Flexibilität insbesondere hinsichtlich der Einstellung des Frequenz- und Phasengangs läßt sich dadurch erreichen, daß am Knoten K (Emitter des Transistors T1) mehrere Kondensatoren C1', C2'... sowie entsprechende einstellbare Netzwerke NW', NW"... angreifen (Fig. 3).

Nachfolgend wird ein Ausführungsbeispiel eines Netzwerkes NW gezeigt, welches aus zwei Transistorstufen - Emitterfolgerstufen EF1 und EF2 - besteht (Fig. 4). Die Einstellung von Betrag und Phase der Ausgangsimpedanz Z erfolgt durch die Einstellung der Emitterströme I1 und I2 dieser in Serie geschalteten Emitterfolgerstufen. Die Einstellung der Ausgangsgleichspannung UA des Netzwerkes NW erfolgt durch Variation der Spannung UST am Eingang (Basis von EF2) des Netzwerkes.

Für die Erklärung der Schaltung werden folgende Vereinfachungen bezüglich der Transistorparameter gemacht:

Basisbahnwiderstand $r_B$=0, Emitter-Sperrschichtkapazität $C_{EB}$=0.

Ferner gilt bei hohen Frequenzen für die:

Stromverstärkung

$$\beta \approx \frac{\omega T}{j\omega} \tag{1}$$

mit $\omega_T = 2\pi f_t$, $f_t$ = Transitfrequenz der Transistoren.

Für die Ausgangsimpedanz eines Emitterfolgers gilt dann:

$$Z_{EF} = \frac{U_T}{I} + \frac{R_G}{\beta} \tag{2}$$

mit $I$ = Kollektorstrom und $R_G$= Innenwiderstand der ansteuernden Quelle.

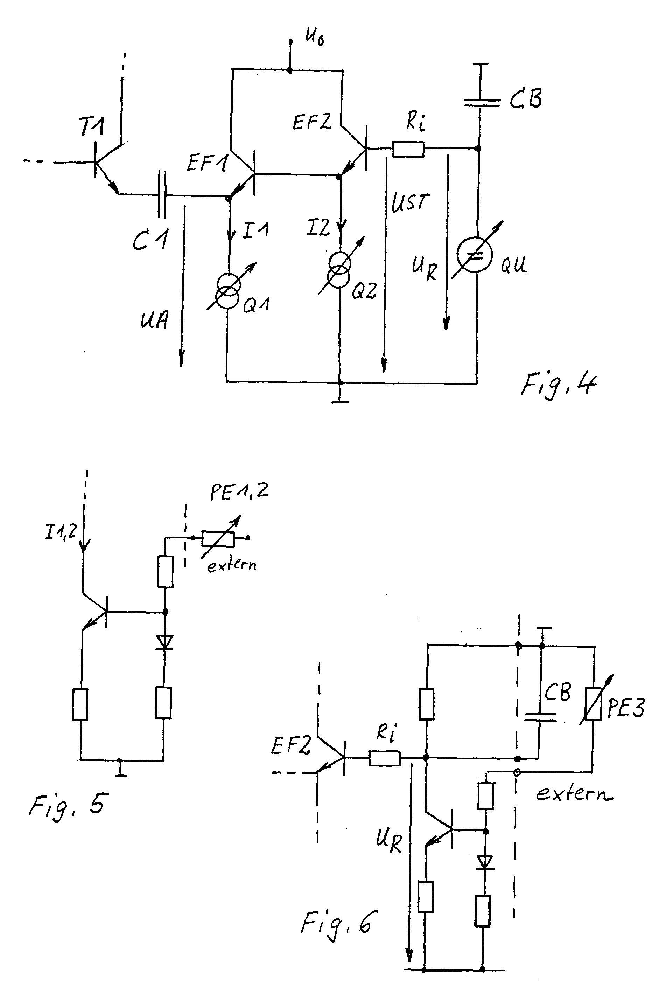

$R_i$ stellt den Innenwiderstand der Spannungsquelle QU mit der Spannung $U_R$ dar. Zur HF-Abblockung ist der Kondensator CB vorgesehen. In den Emitterleitungen der Transistoren EF1 und EF2 sind veränderbare Stromquellen Q1, Q2 vorgesehen, wobei die Emitterströme I1 und I2 dieser Stromquellen in bekannter Weise über Stromspiegelschaltungen und externe Potentiometer PE1,2 eingestellt werden können. Fig. 5 zeigt eine solche geeignete Stromspiegelschaltung mit externem Potentiometer. Auch zur Einstellung der Spannung $U_R$ bzw. $U_{ST}$ kann eine solche Schaltung (Fig. 6) verwendet werden mit einem externen Potentiometer PE3. Für verschiedene Betriebsfälle 1) bis 3). ergeben sich folgende Ergebnisse:

1) $I1 \rightarrow 0$ ⨼ Ausgangsimpedanz des Transistors EF1 nach (2) $Z = Z_{EF1} \rightarrow \infty$ d.h. der Kondensator C1 ist unwirksam. Es wirkt nur noch der Gegenkopplungswiderstand R1.

2) $I1 > 0$ und Annahme $R_i$ =0.

Mit (1) und (2) ergibt sich:

$$Z = Z_{EF1} = \frac{UT}{I1} + j\omega \frac{U_T/I2}{\omega_T} \tag{3}$$

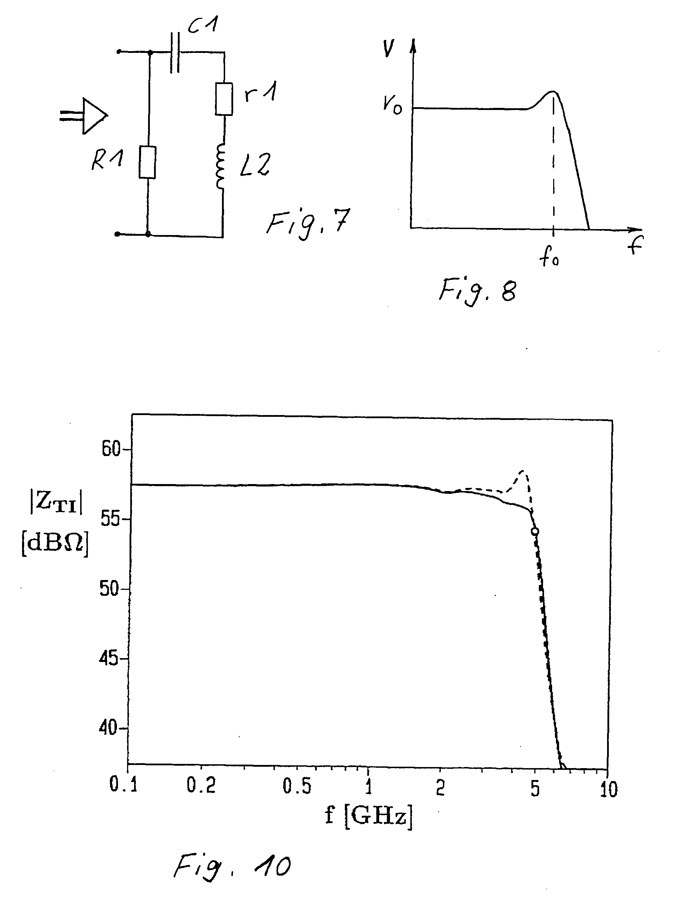

Der Realteil $\frac{U_T}{I1}$ ist im Ersatzschaltbild nach Fig. 7 als Widerstand r1 dargestellt und der Imaginärteil $j\omega L2$ durch die Induktivität L2 berücksichtigt.

Wie Fig. 8 zeigt läßt sich durch einen solchen Betrieb die Verstärkung V bei der Frequenz fo bzw. der entsprechenden Kreisfrequenz

$$\omega_o = 2\pi fo = \frac{1}{\sqrt{L2C1}}$$

anheben.

Die Einstellbarkeit von $\omega_o$ erfolgt über L2 bzw. I2, da

$$L2 \sim \frac{1}{I2} .$$

Die Einstellbarkeit der Dämpfung erfolgt über r1 bzw. I1, da

$$r1 \sim \frac{1}{I1} .$$

Mit $I1 \rightarrow \infty$ ⨼ r1 = 0

sehr schmalbandige Anhebung .
Mit $I2 \to \infty$ stellt im Ersatzschaltbild die Induktivität L2 einen Kurzschluß dar.

3) $I1 > 0$, Annahme $R_i > 0$.
Mit (1) und (2) ergibt sich:

$$Z = Z_{EF1} = \underbrace{\frac{U_T}{I1}}_{r1} + \frac{j\,\omega}{\omega_T}\left(\frac{UT}{I2} + \frac{j\,\omega}{\omega_T} \cdot R_i\right)$$

$$= \underbrace{\frac{U_T}{I1}}_{r1} + j\,\omega\,\underbrace{\frac{UT/I2}{\omega_T}}_{L2} - \left(\frac{\omega}{\omega_T}\right)^2 \cdot R_i$$

Der letzte Term stellt einen nun frequenzabhängigen negativen Widerstand dar.

Wie vorgenannte Beispiele zeigten, sind die Variationsmöglichkeiten sehr groß und daher die erfindungsgemäße Verstärkerstufe an unterschiedliche Parameter eines Übertragungssystems einfach anpaßbar. Auch läßt sich die Verstärkerstufe nach der Erfindung zusammen mit anderen Verstärkerstufen auf einem Chip integrieren. In diesem Falle ist die nachträgliche optimale Einstellbarkeit des Frequenzgangs wegen Entwurfs- und Fertigungstoleranzen von großem Vorteil.

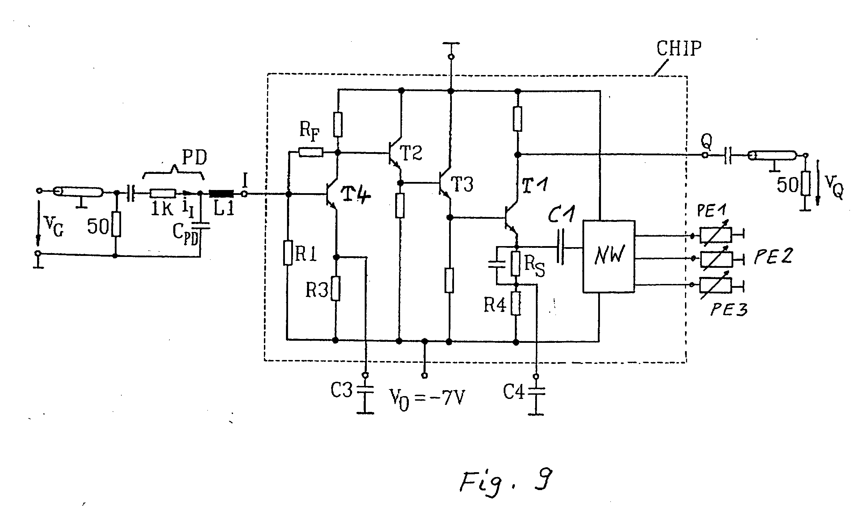

Fig. 9 zeigt den Aufbau eines kompletten Transimpedanz - Vorverstärkers, der am Ausgang die gegengekoppelte Verstärkerstufe mit Einstellnetzwerk NW enthält. Zu beachten ist in Fig. 9, daß das Bezugspotential gegenüber früheren Bildern (Fig. 2) vertauscht ist. Dieser Vorverstärker wird direkt von einer Fotodiode angesteuert, deren Ersatzschaltbild vor dem Eingang I des Vorverstärkers dargestellt ist. Die Transimpedanz liegt bei 750 $\Omega$ und die Datenrate beträgt 6.5 Gbit/s. Der Verstärker besteht aus einer Transimpedanzstufe - Transistor T4 - mit $R_F = 700\ \Omega$, zwei Emitterfolgern T2, T3 zur Impedanztransformation und breitbandiger Pegelverschiebung sowie aus der bereits beschriebenen Transadmittanz-Stufe am Ausgang mit dem Transistor T1 ($R_S = 23\ \Omega$) und dem Netzwerk NW, die auf eine externe Last von 50 $\Omega$ arbeitet. Der Kondensator C1 entspricht dabei dem Kondensator C1 des vorgestellten Beispiels. Die Gegenkopplung über nur eine Stufe am Eingang mittels Widerstand $R_F$ führt im Gegensatz zu bekannten Transimpedanz-Verstärkern zu einer Frequenzgangcharakteristik mit höherer Bandbreite und geringeren Stabilitätsproblemen. Die durch die einstufige Gegenkopplung hervorgerufene Reduktion von $|Z_{TI}|$ bei hohen Frequenzen kann durch die Einstellung des Netzwerks NW kompensiert werden. In Fig. 10 sind zwei Beispiele mit unterschiedlicher Anhebung von $|Z_{TI}|$ durch das Netzwerk NW angegeben. Auch kann mittels dem Netzwerk NW der Phasengang des Verstärkers auf einfache Weise optimiert werden.

Führt man den Widerstand $R_i$ als Diode aus, so kann der Wert von $R_i$ über den Diodenstrom eingestellt werden. Bereits mit der für das Netzwerk NW angegebenen Schaltung hat man zahlreiche Möglichkeiten, Betrag und Phase der Ausgangsimpedanz Z individuell einzustellen. Außerdem ist der Wert des Kondensators C1 über die Spannung $U_R$ bzw. $U_{ST}$ einstellbar (pn-Kondensator). Es sind natürlich auch andere Schaltungen denkbar, die ähnliche Einstellmöglichkeiten bieten.

[1] Ohara et al.: "High gain equalizing amplifier integrated circuits for a gigabit optical repeater". IEEE J. Solid-State Circ. SC-20, 1985, S. 703 - 707

[2] Kinoshita et al.: "Wideband variable peaking AGC amplifier for high-speed lightware digital transmission". Electronics Letters 23, 1987, S. 23 - 24

[3] Reimann u. Rein: "A single-chip bipolar AGC amplifier with large dynamic range for optical-fiber receivers operating up to 3 Gbit/s", IEEE J. Solid-State Circ. 24 (1989), S. 1744 - 1748.

## EP 0 555 748 B1

**Patentansprüche**

1. Gegengekoppelte Verstärkerstufe, insbesondere für Empfangseinrichtungen optischer Übertragungssysteme mit mindestens einem einen Kondensator (C1) enthaltenden Gegenkopplungzweig, wobei in Serie zu diesem Kondensator (C1) ein einstellbares aktives Netzwert (NW) mit komplexer Ausgangsimpedanz (Z), bezogen auf den Anschluß zum den Anschluß zum Kondensator (C1) hin vorgesehen ist, zur individuellen Einstellung von Betrag und Phase des Frequenzgangs der Verstärkerstufe, ohne wesentliche Beeinflussung der NF-Verstärkung, wobei das aktive Netzwerk (NW) so ausgebildet ist, daß die Ausgangsimpedanz eine induktive Komponente aufweist, und wobei die komplexe Ausgangsimpedanz des aktiven Netzwerks durch die Ausgangsimpedanz eines Emitterfolgers gebildet wird.

2. Verstärkerstufe nach Anspruch 1, dadurch gekennzeichnet, daß dem aktiven Netzwerk (NW) zur Variation seiner Ausgangsspannung eine veränderbare Steuerspannung ($U_{ST}$) am Eingang einer seiner Transistorstufen (EF2) zugeführt ist.

3. Verstärkerstufe nach Anspruch 1 oder 2, dadurch gekennzeichnet, daß der Kondensator (C1) derart ausgebildet ist, daß er in Abhängigkeit einer Steuerspannung in seiner Kapazität veränderbar ist.

4. Verstärkerstufe nach Anspruch 3, dadurch gekennzeichnet, daß als Steuerspannung für den Kondensator (C1) die veränderbare Ausgangsspannung des Netzwerkes (NW) verwendet ist.

5. Verstärkerstufe nach einem der Ansprüche 1 bis 4, dadurch gekennzeichnet, daß das Netzwerk (NW) zweistufig aufgebaut ist, wobei in der einen Stufe (EF1) Einstellmittel (I1) für den Betrag und in der anderen Stufe (EF2) Einstellmittel (I2) für die Phase vorgesehen sind.

6. Verstärkerstufe nach Anspruch 5, dadurch gekennzeichnet, daß das Netzwerk (NW) aus der Serienschaltung zweier insbesondere als Emitterfolger ausgebildeter Transistorstufen (EF1, EF2) besteht, wobei dem Netzwerk (NW) eingangsseitig eine veränderbare Steuerspannung zuführbar ist.

7. Verstärkerstufe nach Anspruch 6, dadurch gekennzeichnet, daß zwischen der Spannungsquelle (QU) und dem Eingang der Transistorstufen (EF1, EF2) ein veränderbarer Widerstand (Ri) vorgesehen ist.

8. Verstärkerstufe nach einem der Ansprüche 5 bis 7, dadurch gekennzeichnet, daß als Einstellmittel (I1, I2) veränderbare Stromquellen, insbesondere in den Emitterleitungen der Transistorstufen (EF1, EF2), vorgesehen sind.

9. Verstärkerstufe nach Anspruch 8, dadurch gekennzeichnet, daß als veränderbare Stromquellen Stromspiegelschaltungen mit externen Potentiometern vorgesehen sind.

10. Verwendung der Verstärkerstufe nach einem der Ansprüche 1 bis 9 als Ausgangsstufe eines Vorverstärkers, welcher insbesondere direkt mit dem Empfangssignal einer Fotodiode (PD) beaufschlagt ist.


**Claims**

1. Amplifier stage with negative feedback, in particular for receiving devices of optical transmission systems having at least one negative feedback path which contains a capacitor (C1), this capacitor (C1) having connected in series with it an adjustable active network (NW) with a complex output impedance (Z) related to the connection towards the connection to the capacitor (C1), for individual adjustment of the magnitude and phase of the frequency response of the amplifier stage, without any significant influence on the AF gain, the active network (NW) being designed such that the output impedance has an inductive component, and the complex output impedance of the active network being formed by the output impedance of an emitter follower.

2. Amplifier stage according to Claim 1, characterized in that, in order to vary its output voltage, the active network (NW) is supplied with a variable control voltage ($U_{ST}$) at the input of one of its transistor stages (EF2).

3. Amplifier stage according to Claim 1 or 2, characterized in that the capacitor (C1) is designed in such a manner that its capacitance is variable as a function of a control voltage.

5

4. Amplifier stage according to Claim 3, characterized in that the control voltage for the capacitor (C1) is the variable output voltage of the network (NW).

5. Amplifier stage according to one of Claims 1 to 4, characterized in that the network (NW) is designed with two stages, adjusting means (I1) for the magnitude being provided in one stage (EF1), and adjusting means (I2) for the phase being provided in the other stage (EF2).

6. Amplifier stage according to Claim 5, characterized in that the network (NW) is composed of a series circuit formed by two transistor stages (EF1, EF2) which are designed, in particular, as emitter followers, it being possible to supply a variable control voltage to the input side of the network (NW).

7. Amplifier stage according to Claim 6, characterized in that a variable resistor (Ri) is provided between the voltage source (QU) and the input of the transistor stages (EF1, EF2).

8. Amplifier stage according to one of Claims 5 to 7, characterized in that variable current sources, in particular in the emitter lines of the transistor stages (EF1, EF2), are provided as adjusting means (I1, I2).

9. Amplifier stage according to Claim 8, characterized in that current mirror circuits with external potentiometers are provided as variable current sources.

10. Use of the amplifier stage according to one of Claims 1 to 9 as an output stage of a pre-amplifier to which, in particular, the input signal of a photodiode (PD) is applied directly.


**Revendications**

1. Etage amplificateur à contre-réaction, notamment pour des récepteurs de système de transmission optique comprenant au moins une branche de contre-réaction munie d'un condensateur (C1), avec en série sur ce condensateur (C1), un réseau actif réglable (NW) à impédance complexe (Z) rapporté au branchement du condensateur (C1), pour le réglage individuel de l'amplitude et de la phase de la fréquence d'un étage amplificateur sans influencer de manière significative l'amplification (BF), le réseau actif (NW) étant réalisé pour que l'impédance de sortie présente une composante inductive et que l'impédance de sortie, complexe du réseau actif soit formée par l'impédance de sortie d'un montage en émetteur commun.

2. Etage amplificateur selon la revendication 1, caractérisé en ce que pour modifier sa tension de sortie, l'entrée de l'un des étages de transistor (EF2) du réseau actif, reçoit une tension de commande ($U_{st}$) variable.

3. Etage amplificateur selon la revendication 1 ou 2, caractérisé en ce que le condensateur (C1) est réalisé pour que sa capacité soit variable en fonction d'une tension de commande.

4. Etage amplificateur selon la revendication 3, caractérisé en ce que comme tension de commande du condensateur (C1), on utilise la tension de sortie variable du réseau (NW).

5. Etage amplificateur selon l'une des revendications 1 à 4, caractérisé en ce que le réseau (NW) est à deux étages, le premier étage (EF1) comportant un moyen de réglage (I1) pour l'amplitude et l'autre étage (EF2) comportant un moyen de réglage (I2) pour la phase.

6. Etage amplificateur selon la revendication 5, caractérisé en ce que le réseau (NW) est formé du montage en série de deux étages à transistors (EF1, EF2) en émetteurs communs, l'entrée du réseau (NW) recevant une tension de commande variable.

7. Etage amplificateur selon la revendication 6,

caractérisé par
une résistance variable (Ri) est prévue entre la source de tension (QU) et l'entrée des étages de transistor (EF1, EF2).

8.  Etage amplificateur selon l'une des revendications 5 à 7,
    caractérisé en ce que
    les moyens de réglage (I1, I2) sont des sources de courant variable notamment dans les lignes des émetteurs des étages à transistors (EF1, EF2).

9.  Etage amplificateur selon la revendication 8,
    caractérisé en ce que
    les sources d'intensité variable sont des miroirs de courant avec des potentiomètres externes.

10. Application de l'étage amplificateur selon l'une des revendications 1 à 9 comme étage de sortie d'un préamplificateur recevant notamment directement le signal d'entrée d'une photodiode (PD).

Fig.1

Fig.2

Fig.3

Fig. 4

Fig. 5

Fig. 6

Fig. 7

Fig. 8

Fig. 10

Fig. 9